(19)

Europäisches
Patentamt
European
Patent Office
Office européen
des brevets

(11) **EP 2 322 865 A1**

(12) **EUROPEAN PATENT APPLICATION**
published in accordance with Art. 153(4) EPC

(43) Date of publication:
**18.05.2011 Bulletin 2011/20**

(21) Application number: **08791459.4**

(22) Date of filing: **23.07.2008**

(51) Int Cl.:
*F24F 11/04* *(2006.01)*  *F24F 7/06* *(2006.01)*
*G06F 1/20* *(2006.01)*  *H05K 7/20* *(2006.01)*

(86) International application number:
**PCT/JP2008/063202**

(87) International publication number:
**WO 2010/010617 (28.01.2010 Gazette 2010/04)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Fujitsu Limited**
**Kawasaki-shi, Kanagawa 211-8588 (JP)**

(72) Inventors:
• **SUZUKI, Masahiro**
**Kawasaki-shi**
**Kanagawa 211-8588 (JP)**
• **KATSUI, Tadashi**
**Kawasaki-shi**
**Kanagawa 211-8588 (JP)**

• **ISHIMINE, Junichi**
**Kawasaki-shi**
**Kanagawa 211-8588 (JP)**
• **OHBA, Yuji**
**Kawasaki-shi**
**Kanagawa 211-8588 (JP)**
• **TOMINAGA, Sayoko**
**Kawasaki-shi**
**Kanagawa 211-8588 (JP)**
• **NAGAMATSU, Ikuro**
**Kawasaki-shi**
**Kanagawa 211-8588 (JP)**

(74) Representative: **Kreutzer, Ulrich**
**Cabinet Beau de Loménie**
**Bavariaring 26**
**80336 München (DE)**

(54) **INFORMATION PROCESSING SYSTEM AND METHOD FOR CONTROLLING THE SAME**

(57) An information processing apparatus system (11) includes an information processing apparatus or apparatuses configured to measure the flow rate of coolant flowing from a coolant inflow surface (15) of its enclosure to a coolant outflow surface (16) of the enclosure. A circulating path of the coolant is formed from the coolant outflow surface (16) to the coolant inflow surface (15). A cooling apparatus (29) controls the discharged amount of the coolant based on the measured flow rate. The information processing apparatus system enables a reliable supply of the coolant in an amount not excessive and without shortage to the information processing apparatus or apparatuses. The information processing apparatus or apparatuses can reliably be cooled.

FIG.4

EP 2 322 865 A1

**Description**

FIELD

The embodiments discussed herein are related to an information processing apparatus system including: an information processing apparatus or apparatuses having a ventilator or ventilators configured to generate flow of coolant or a cooling medium from an intake surface of an enclosure to a discharge surface of the enclosure; and an air conditioner configured to supply the coolant toward the intake surface.

BACKGROUND

An information processing apparatus such as a so-called rack-mount server is well known. The rack-mount server or servers are mounted in a rack, for example. A ventilator is mounted in the individual rack-mount server. The ventilator is configured to generate the flow of coolant or a cooling medium from an intake surface of an enclosure to a discharge surface of the enclosure. The flow of coolant serves to prevent electronic components such as a CPU and a controller in the enclosure from suffering from a large increase in temperature.

Publication 1: JP Utility Model Application Laid-open No. 6-29195
Publication 2: JP Patent Application Laid-open No. 2006-64303
Publication 3: JP Patent Application Laid-open No. 2003-166729

DISCLOSURE OF THE INVENTION

Racks are placed in a room inside a data center. An air conditioner is disposed in the room. The air conditioner is designed to supply a cool air to intake surfaces of the individual rack-mount servers. However, the data center is not configured to supply a sufficient cool air to all the rack-mount servers. So-called hot spots are often generated in the room. This results in a concern that the electronic components suffer from an increase in temperature.
It is accordingly an object in one aspect of the embodiment to provide an information processing apparatus system capable of reliably cooling an information processing apparatus or apparatuses with the work of an air conditioner. It is an object in another aspect of the embodiment to provide a method of controlling such an information processing apparatus system. It is an object of still another aspect of the embodiment to provide an information processing apparatus and a method of cooling the same both contributing to realization of such an information processing apparatus system.
According to an aspect of the invention, an information processing apparatus system, includes: an information processing apparatus or apparatuses configured to measure the flow rate of coolant flowing from a coolant inflow surface of its enclosure to a coolant outflow surface of the enclosure; and a cooling apparatus configured to form a circulating path of the coolant from the coolant outflow surface to the coolant inflow surface, the cooling apparatus configured to control the discharged amount of the coolant based on the measured flow rate.
The information processing apparatus system enables a reliable supply of the coolant in an amount not excessive and without shortage to the information processing apparatus or apparatuses. The information processing apparatus or apparatuses can reliably be cooled.
A method of controlling an information processing apparatus system, the method comprises: measuring, at an information processing apparatus or apparatuses, flow rate of coolant flowing from a coolant inflow surface of an enclosure of the information processing apparatus or individual one of the information processing apparatuses to a coolant outflow surface of the enclosure; and controlling, based on the measured flow rate, the discharged amount of the coolant from a cooling apparatus configured to form a circulating path of the coolant from the coolant outflow surface of the enclosure to the coolant inflow surface of the enclosure.
In order to realize the information processing apparatus system, an information processing apparatus comprises: an enclosure enclosing an object to be cooled; an inflow temperature measuring section configured to measure the temperature of coolant flowing into the enclosure through a coolant inflow surface of the enclosure; an outflow temperature measuring section configured to measure the temperature of the coolant flowing out of the enclosure through a coolant outflow surface of the enclosure; a power consumption measuring section configured to measure the power consumption of the object; and a controlling section configured to calculate the flow rate of the coolant flowing from the coolant inflow surface to the coolant outflow surface based on the temperature measured at the inflow temperature measuring section, the temperature measured at the outflow temperature measuring section and the power consumption measured at the power consumption measuring section.
A method of cooling an information processing apparatus, the method comprises: measuring the temperature of coolant flowing into an enclosure through a coolant inflow surface of the enclosure, the enclosure enclosing an object to be cooled; measuring the temperature of the coolant flowing out of the enclosure through a coolant outflow surface of he enclosure; measuring the power consumption of the object; and calculating the flow rate of the coolant flowing from the coolant inflow surface to the coolant outflow surface based on the temperature measured at the inflow temperature measuring section, the temperature measured at the outflow temperature measuring section and the power consumption measured at the power consumption measuring section.

BRIEF DESCRIPTION OF THE DRAWINGS

FIG. 1 is a schematic view illustrating the entire structure of an information processing apparatus system according to a first embodiment;
FIG. 2 is an enlarged perspective view schematically illustrating the structure of a rack-mount server;
FIG. 3 is a block diagram schematically illustrating the control system of the information processing apparatus system;
FIG. 4 is an overall view of the information processing apparatus system for illustrating the flow of air;
FIG. 5 is a schematic view illustrating the structure of a rack-mount server according to another embodiment;
FIG. 6 is a schematic view illustrating the structure of a rack-mount server according to still another embodiment;
FIG. 7 is a schematic view illustrating the structure of a rack-mount server according to still another embodiment;
FIG. 8 is a schematic view illustrating the structure of a rack-mount server according to still another embodiment;
FIG. 9 is a schematic view illustrating the entire structure of an information processing apparatus system according to a second embodiment;
FIG. 10 is an enlarged perspective view schematically illustrating the structure of a blade server; and
FIG. 11 is a block diagram schematically illustrating the control system of the information processing apparatus system.

BEST MODE FOR CARRYING OUT THE INVENTION

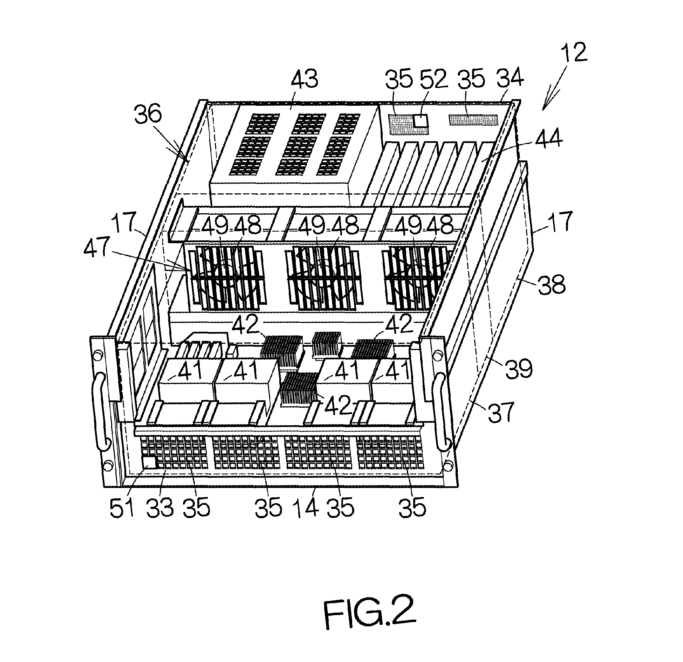

Embodiment(s) of the present invention will be explained below with reference to the accompanying drawings.

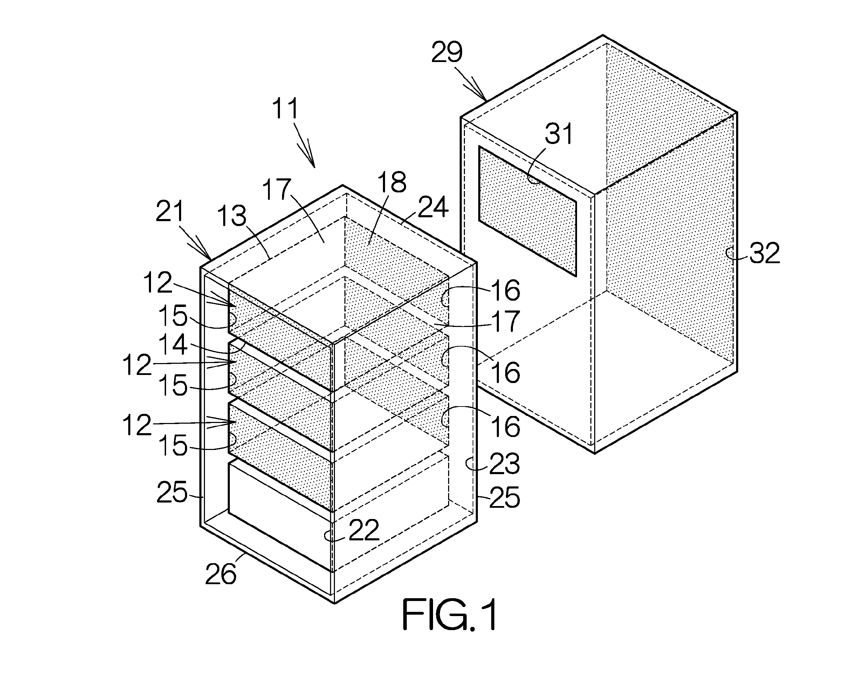

FIG. 1 schematically illustrates the overall structure of an information processing apparatus system 11 according to a first embodiment. The information processing apparatus system 11 includes an information processing apparatus or apparatuses, namely a rack-mount server or servers 12. The rack-mount server 12 includes an enclosure 13. The enclosure 13 defines a hollow on a bottom plate 14 of a rectangular shape. The hollow extends from a front-side opening 15 to a rear-side opening 16. The hollow is a space in the shape of a parallelepiped. The bottom plate 14 defines the bottom of the space of the parallelepiped. The front-side opening 15 defines the front surface of the space of the parallelepiped. The front-side opening 15 corresponds to a coolant inflow surface or an intake surface. The rear-side opening 16 defines the rear surface of the space of the parallelepiped. The rear-side opening 16 corresponds to a coolant outflow surface or a discharge surface. A pair of side surfaces of the space of the parallelepiped are covered with side panels 17, respectively. The side panels 17 are opposed to each other, and extend between the front-side opening 15 and the rear-side opening 16. The lower ends of the respective side panels 17 are coupled to the bottom plate 14. The top surface of the space of the parallelepiped is covered with a top plate 18. The top plate 18 is opposed to the bottom plate 14, and extend between the front-side opening 15 and the rear-side opening 16. Coolant or cooling medium, namely air flows into the enclosure 13 through the front-side opening 15, as described later in detail. The air flows out of the enclosure 13 through the rear-side opening 16. The rack-mount servers 12 are mounted on a rack 21. The rack 21 defines a front opening 22 and a rear opening 23. The front-side opening 15 faces the front opening 22 of the rack 21. The rear-side opening 16 faces the rear opening 23 of the rack 21. The rack 21 has a top panel 24, left and right side panels 25 and bottom panels 26 for defining the front opening 22 and the rear opening 23.
The information processing apparatus system 11 includes a cooling apparatus, specifically an air conditioner. The air conditioner 29 includes an intake opening 31 formed at the front of the air conditioner 29. The intake opening 31 is opposed to the rear opening 23 of the rack 21. A predetermined space is formed between the front of the air conditioner 29 and the back of the rack 21. A discharge opening 32 is formed at the back of the air conditioner 29. Air is sucked into the air conditioner 29 through the intake opening 31 and discharged out of the air conditioner 29 through the discharge opening 32.
As depicted in FIG. 2, the front-side opening 15 is closed with a front panel 33 in the individual rack-mount server 12. The rear-side opening 16 is closed with a rear panel 34. Gratings 35 are formed in the front panel 33 and the rear panel 34 for intake and discharge of air.
A first space 37 is defined in a parallelepiped-shaped space 36 at a position closest to the front-side opening 15. A second space 38 is defined in the parallelepiped-shaped space 36 at a position closest to the rear-side opening 16. A third space 39 is defined between the first space 37 and the second space 38. The third space 39 is interposed between the first space 37 and the second space 38. Specifically, the parallelepiped-shaped space 36 is divided into the first space 37, the third space 39 and the second space 38 in this sequence from the front end.

Electronic components having a relatively small height are placed in the first space 37. Such electronic components include CPU chip packages 41 and controller chip packages 42, for example. The CPU chip packages 41 and the controller chip packages 42 are mounted on a printed wiring board. The printed wiring board extends along a horizontal plane. A motherboard is in this manner established. The CPU chip packages 41 and the controller chip packages 42 include heat sinks, for example, respectively. The individual heat sink includes cooling fins. The cooling fins extend in parallel with the side surface of the parallelepiped-shaped space 36. A set of memory modules 43, a set of PCI cards 44, hard disk drives (HDDs), and the like are placed in the second space 38, for example. The motherboard as well as the HDDs generate heat during operations.

A fan unit 47 is placed in the third space 39. The fan unit 47 separates the first space 37 and the second space 38 from each other. The fan unit 47 includes axial fans 48. The individual axial fan 48 rotates blades around a rotation axis 49 extending in parallel with the bottom surface of the parallelepiped-shaped space 36. Here, pairs of the axial fans 48, 48, namely the front and rear axial fans 48, 48 having the coaxial rotation axes 49, 49 are arranged in three rows. The axial fans 48, six in total, are coupled to one another. Airflow is generated from the first space 37 to the second space 38 in response to the rotation of the blades.

An inflow temperature sensor 51 and an outflow temperature sensor 52 are placed in the enclosure 13 of the rack-mount server 12. The inflow temperature sensor 51 is located in the front-side opening 15, namely at the intake surface. The inflow temperature sensor 51 is configured to detect the temperature of air flowing into the enclosure 13 through the front-side opening 15, namely the intake air temperature. The inflow temperature sensor 51 provides an inflow temperature measuring section. On the other hand, the outflow temperature sensor 52 is located in the rear-side opening 16, namely at the discharge surface. The outflow temperature sensor 52 is configured to detect the temperature of air flowing out of the enclosure 13 through the rear-side opening 16, namely the discharged air temperature. The outflow temperature sensor 52 provides an outflow temperature measuring section.

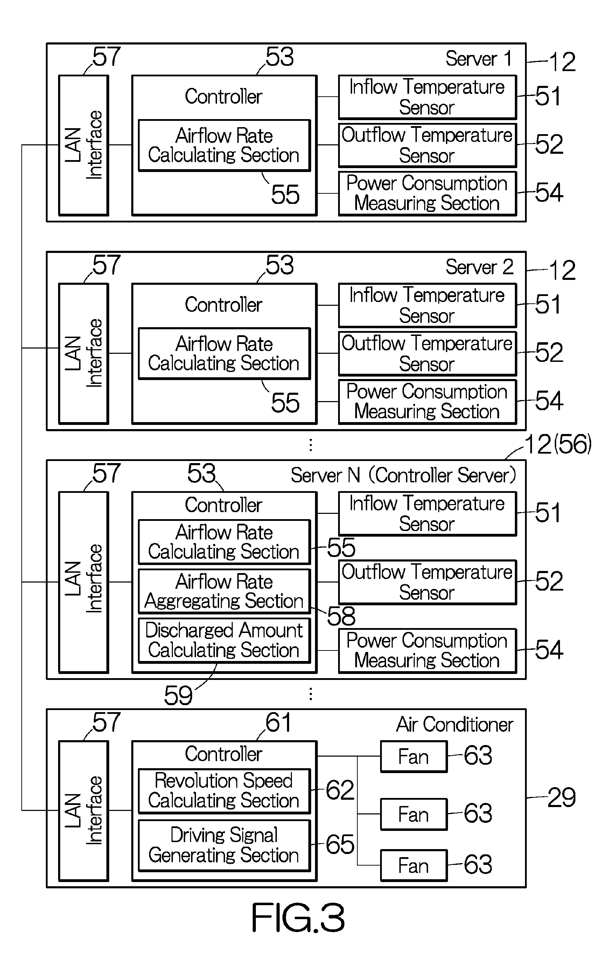

FIG. 3 illustrates the control system of the information processing apparatus system 11. The individual rack-mount server 12 includes a controlling section, namely a controller 53. The aforementioned inflow temperature sensor 51 and outflow temperature sensor 52 are connected to the controller 53. An intake temperature signal and a discharge temperature signal are supplied to the controller 53 from the inflow temperature sensor 51 and the outflow temperature sensor 52. The intake temperature signal specifies the intake air temperature. The discharge temperature signal specifies the discharged air temperature.

A power consumption measuring section 54 is connected to the controller 53. The power consumption measuring section 54 is configured to measure the power consumption for the individual electronic components or for the entire structure of the server. The power consumption measuring section 54 supplies a power consumption amount signal to the controller 53. The power consumption amount signal specifies the amount of the power consumption. The quantity of heat or heating energy of the electronic component or the server can be calculated based on the amount of the power consumption.

An airflow rate calculating section 55 is established in the controller 53. The intake temperature signal, the discharge temperature signal and the power consumption amount signal are supplied to the airflow rate calculating section 55. The airflow rate calculating section 55 calculates the quantity of heat at the electronic component or components based on the amount of the power consumption. The airflow rate calculating section 55 is configured to calculate the flow rate $\underline{U}$ of the airflow based on the intake air temperature $T_{in}$, the discharged air temperature Tout, the amount $\underline{P}$ of the power consumption, the air density p, and the specific heat $C_p$ in accordance with the following equation:

[EQUATION 1]

$$U = \frac{P}{\rho \, Cp(T_{out} - T_{in})} \quad \cdots (1)$$

The airflow rate calculating section 55 outputs an airflow rate information signal. The airflow rate information signal specifies the airflow rate $\underline{U}$ (volume per unit time). When the airflow rate calculating section 55 calculates the airflow rate, the airflow rate calculating section 55 refers to the mounting position and/or the number of heat generating components such as the CPU chip package and the HDDs, and the mounting position and/or the number of the option boards. This type of information may be stored in a memory installed in the controller 53, for example.

One of the rack-mount servers 12 is designated as a controller server 56. The remainder of the rack-mount servers 12 is connected to the controller server 56. LAN interfaces 57 are utilized to establish such connection, for example. An airflow rate aggregating section 58 is established in the controller 53 of the controller server 56. The airflow rate information signals are supplied to the airflow rate aggregating section 58 from the individual rack-mount servers 12. The airflow rate aggregating section 58 aggregates the airflow rate for the entire rack 21 based on the airflow rate information signals.

A discharged amount calculating section 59 is established in the controller 53 of the controller server 56. The discharged amount calculating section 59 calculates the discharged amount of the air conditioner 29 based on the aggregated airflow rate. This discharged amount corresponds to the flow rate of a cooling air discharged from the discharge opening 31 of the air conditioner 29. The discharged amount calculating section 59 generates a control signal based on the calculated discharged amount. The control signal specifies the discharged amount. The discharged amount is set at 1.1-1.2 times the aggregated airflow rate approximately. When the discharged amount calculating section 59 calculates the discharged amount, the discharged amount calculating section 59 refers to the type of the air conditioner 29, the type of the rack 21, the distance between the rack 21 and the air conditioner 29, and other environmental information. This type of information may be stored in a memory installed in the controller 53, for example.

The controller 53 of the controller server 56 is connected to a controller 61 of the air conditioner 29. The LAN interfaces 57 are utilized to realize such connection, for example. A revolution speed calculating section 62 is established in the controller 61 of the air conditioner 29. The aforementioned control signal is supplied to the revolution speed calculating section 62. The revolution speed calculating section 62 calculates the revolution speed of the individual fans 63 based on the discharged amount. The discharged amount is determined based on the revolution speed of the fans 63. A relationship is determined between the revolution speed of the fans 36 and the flow rate. Such a relationship is stored in a memory installed in the controller 61, for example. When the revolution speed calculating section 62 calculates the revolution speed, the revolution speed calculating section 62 refers to the type of the air conditioner 29, component information such as a filter, and other environmental information. This type of information may be stored in a memory installed in the controller 61, for example.

A driving signal generating section 65 is established in the controller 61 of the air conditioner 29. The driving signal generating section 65 generates a driving signal based on the revolution speed obtained at the revolution speed calculating section 62. When the generated driving signal is supplied to the individual fans 63, the fans 63 are forced to rotate at the designated revolution speed. The discharged amount of the air conditioner 29 is in this manner managed based on the control of the revolution speed.

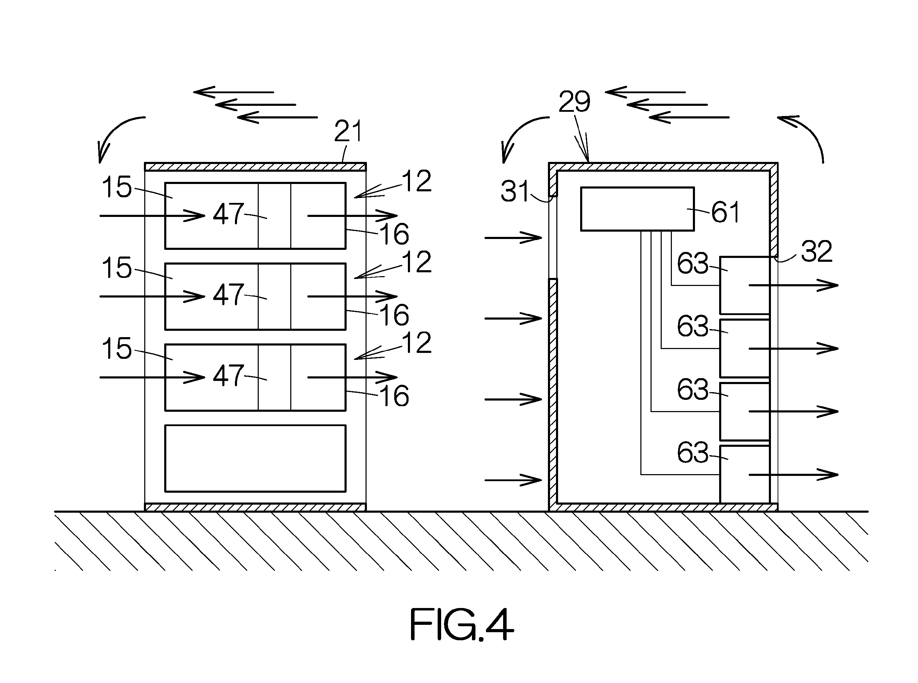

As depicted in FIG. 4, when the fan units 47 operate, the flow of coolant, namely air is generated in the individual rack-mount server 12 from the front-side opening 15 namely the intake surface to the rear-side opening 16 namely the discharge surface. The air receives heat from objects to be cooled, such as the motherboard and the HDDs. The airflow serves to cool the motherboard and the HDDs. The airflow flows out of the enclosure 13 through the rear-side opening 16.

The heated air is sucked into the air conditioner 29 through the intake opening 31. The air conditioner 29 cools the air based on a conventional refrigeration cycle. The cool air is discharged from the discharge opening 32. The air conditioner 29 forms a circulating path of the air from the rear-side opening 16 of the rack-mount server 12 to the front-side opening 15 of the rack-mount server 12. The air conditioner 29 in this manner works to supply the cool air to the rack-mount servers 12.

When the individual rack-mount servers 12 operate, the motherboards and the HDDs generate heat. The discharged air temperature rises. The controller 53 controls the flow rate of air discharged from the axial fans 48 based on a temperature difference between the discharged air temperature and the intake air temperature. When the temperature difference increases, the controller 53 increases the revolution speed of the blades around the rotation axes 49. To the contrary, when the temperature difference decreases, the controller 53 reduces the revolution speed of the blades around the rotation axes 49. The flow rate of the airflow flowing through the parallelepiped-shaped space 36 varies in the individual rack-mount server 12.

Here, a brief description will be made on a method of controlling the discharged amount of the air conditioner 29. First of all, the controller server 56 requests the individual rack-mount servers 12 to measure the airflow rate in the individual rack-mount servers 12. Instruction signals are supplied to the individual rack-mount servers 12, respectively, through the LAN interfaces 57. The controller 53 receives the intake temperature signal and the discharge temperature signal from the inflow temperature sensor 51 and the outflow temperature sensor 52, respectively, in response to the reception of the instruction signal. At the same time, the controller 53 obtains the power consumption amount signal from the power consumption measuring section 54. The airflow rate calculating section 55 calculates the flow rate of the airflow based on the intake air temperature, the discharged air temperature and the amount of the power consumption in the aforementioned manner. The airflow rate calculating section 55 outputs the airflow rate information signal. The airflow rate information signal is supplied to the controller server 56 through the LAN interfaces 57.

The controller 53 of the controller server 56 receives the airflow rate information signals from all the rack-mount servers 12. The airflow rate aggregating section 58 aggregates the airflow rate for the rack-mount server or servers 12 in operation in the rack 21. The airflow rate is summed. The required airflow rate for the rack 21 is in this manner calculated. The discharged amount calculating section 59 calculates the discharged amount of the air conditioner 29 based on the required airflow rate. Here, the required airflow rate is multiplied by a predetermined coefficient. The predetermined coefficient is set in a range between 1.1 and 1.2 approximately, for example. The discharged amount is in this manner set larger than the required airflow rate. The discharged amount calculating section 59 generates the control signal based on the calculated discharged amount. The generated control signal is outputted to the air conditioner 29 through the LAN interfaces 57.

The controller 61 of the air conditioner 29 controls the action of the fans 63 in response to the reception of the control signal. The revolution speed calculating section 62 determines the revolution speed of the fans 63 based on the discharged amount. The driving signal generating section 65 generates the driving signal based on the determined revolution speed. The fans 63 operate at the designated revolution speed. As a result, the discharged amount of the air conditioner 29 is controlled. The cool air is in this manner supplied to the individual rack-mount servers 12 in an amount not excessive and without shortage. Generation of hot spots is avoided. An efficient cooling of the rack-mount servers 12 is realized. As a result, the power consumption can be reduced.

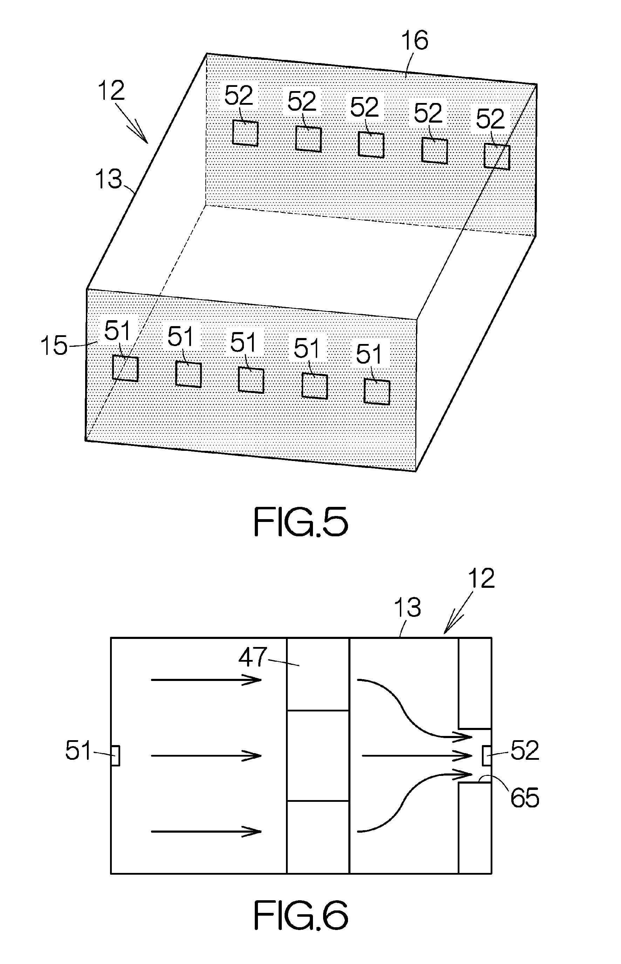

As depicted in FIG. 5, a plurality of the inflow temperature sensors 51 and the outflow temperature sensors 52 may be disposed in the front-side opening 15 and the rear-side opening 16 in the rack-mount server 12, for example. Specifically, measurement points are located in predetermined regions, respectively, in the front-side opening 15 and the rear-side opening 16. The temperature of air is measured at the respective measurement points. The individual inflow temperature sensor 51 outputs the intake temperature signal. The individual outflow temperature sensor 52 outputs the discharge temperature signal. The outputted intake temperature signal and discharge temperature signal are supplied to the controller 53.

When the airflow rate calculating section 55 in the controller 53 calculates the airflow rate, the airflow rate calculating section 55 determines the intake air temperature $T_{in}$ based on all the intake temperature signals. When the airflow rate calculating section 55 determines the intake air temperature $T_{in}$, the airflow rate calculating section 55 calculates the average value of the temperatures specified in the intake temperature signals. Likewise, when the airflow rate calculating section 55 calculates the airflow rate, the airflow rate calculating section 55 determines the discharged air temperature Tout based on all the discharge temperature signals. When the airflow rate calculating section 55 determines the discharged air temperature Tout, the airflow rate calculating section 55 calculates the average value of the temperatures specified in the discharge temperature signals. The enhanced accuracy of the intake air temperature and the discharged air temperature in this manner serves to allow the airflow rate calculating section 55 to determine the flow rate $\underline{U}$ of the airflow with high accuracy.

Furthermore, a constriction 65 may be defined in at least one of the front-side opening 15 and the rear-side opening 16 in the rack-mount server 12, as depicted in FIG. 6, for example. The constriction 65 is configured to narrow the passage of the airflow in the parallelepiped-shaped space 36. As a result, the range of the airflow is reduced. The temperature of the airflow can be specified with high accuracy with less measurement points. The airflow rate calculating section 55 is allowed to determine the flow rate $\underline{U}$ of the airflow with higher accuracy.

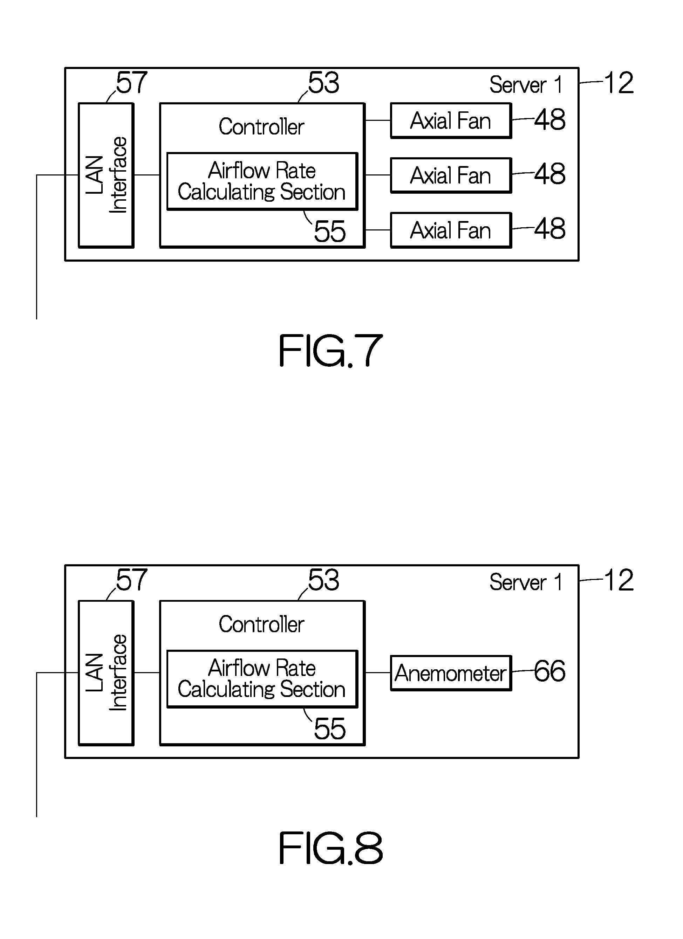

The airflow rate can be calculated based on the revolution speed of the axial fans 48 in the rack-mount server 12. In this case, the revolution speed is specified for the individual axial fans 48. A revolution speed signal is supplied to the airflow rate calculating section 55 from the axial fan 48. The revolution speed signal specifies the revolution speed of the blades around the rotation axis 49. In the case where the revolution speed of the individual axial fan 48 is independently controlled, the revolution speed signals may be supplied to the airflow rate calculating section 55 from the individual axial fans 48, as depicted in FIG. 7. In the case where the revolution speed is commonly controlled for a set of the axial fans 48, the revolution speed signal may be supplied to the airflow rate calculating section 55 from any one of the axial fans 48. The axial fan 48 may employ a revolution speed sensor such as an encoder so as to determine the revolution speed of the axial fan 48, for example. The revolution speed may be determined based on the voltage value, the current value, the width of the pulse, or the like, of the driving signal supplied to the axial fan 48 in place of the aforementioned revolution speed sensor. The airflow rate calculating section 55 in this manner calculates the airflow rate based on the revolution speed signal. The airflow rate is previously determined depending on the magnitude of the revolution speed in the individual axial fan 48. Such a relationship between the revolution speed and the airflow rate may be stored in a memory installed in the controller 53, for example.

Furthermore, an anemometer 66 may be installed in the rack-mount server 12, as depicted in FIG. 8, for example. The anemometer 66 may be disposed in any one of the front-side opening 15 and the rear-side opening 16, for example. The anemometer 66 is configured to detect the speed of the airflow. The anemometer 66 generates a airflow speed value signal based on the detected value. The airflow speed value signal is supplied to the airflow rate calculating section 55 from the anemometer 66. The airflow rate calculating section 55 determines the speed of the airflow based on the speed of the airflow and the sectional area of the opening. The sectional area may be specified at the front opening 16 and the rear-side opening 16. The value of the sectional area is previously stored in a memory in the controller 53. It is preferable to define the constriction 65 in the enclosure 13 for disposition of the anemometer in the aforementioned manner. The anemometer may be located in the constriction 65. The constriction 65 works to equalize the speed of the airflow over the sectional area.

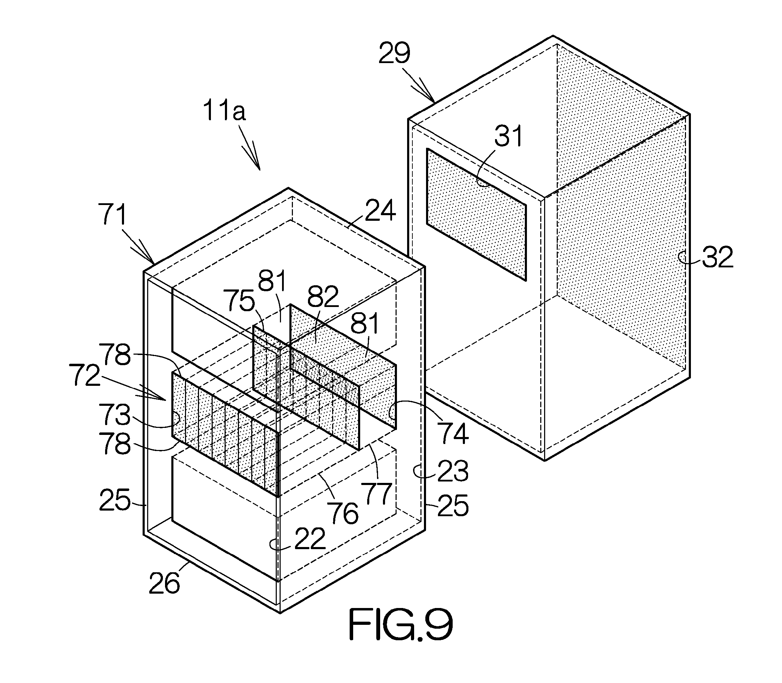

FIG. 9 schematically illustrates the overall structure of an information processing apparatus system 11a according to a second embodiment. The information processing apparatus system 11a includes so-called blade servers 71. The blade server 71 includes an enclosure, namely a chassis 72. The chassis 72 defines a hollow extending from a front-side opening 73 to a rear-side opening 74. The front-side opening 73 corresponds to a coolant inflow surface or intake surface. The rear-side opening 74 corresponds to a coolant outflow surface or a discharge surface. The chassis 72 is mounted on the rack 21. The rack 21 defines the front opening 22 and the rear opening 23. The front-side opening 73 faces the front opening 22 of the rack 21. The rear-side opening 74 faces the rear opening 23 of the rack 21. The rack 21 has a top panel 24, left and right side panels 25 and bottom panels 26 for defining the front opening 22 and the rear opening 23. Like reference numerals or characters are attached to components or structure equivalent to those of the aforementioned information processing apparatus system 11.

A single backplate 75 is installed in the chassis 72. The backplate 75 extends in the vertical direction. The backplate 75 serves to divide a parallelepiped-shaped space inside the chassis 72 into a front-side space 76 and a rear-side space 77. A server blade or blades 78, namely an information processing apparatus unit or units, are placed in the front-side space 76. The server blades 78 are inserted into the chassis 72 in the vertical attitude. The server blades 78 are coupled to the front surface of the backplate 75. Power source units 81, a fan unit 82, a management blade, not depicted, and the like, are placed in the rear-side space 77. The power source units 81, the fan unit 82 and the management blade are coupled to the back surface of the backplate 75. The backplate 75 serves to distribute the electric power, supplied from the power source units 81, to the individual server blades 78. The fan unit 82 includes axial fans, for example, in the same manner as the aforementioned fan unit 47. The individual axial fan rotates blades around a rotation axis extending along the horizontal imaginary plane from the front-side to the rear-side. Airflow is generated from the front-side opening 73 to the rear-side opening 74 in response to the rotation of the blades.

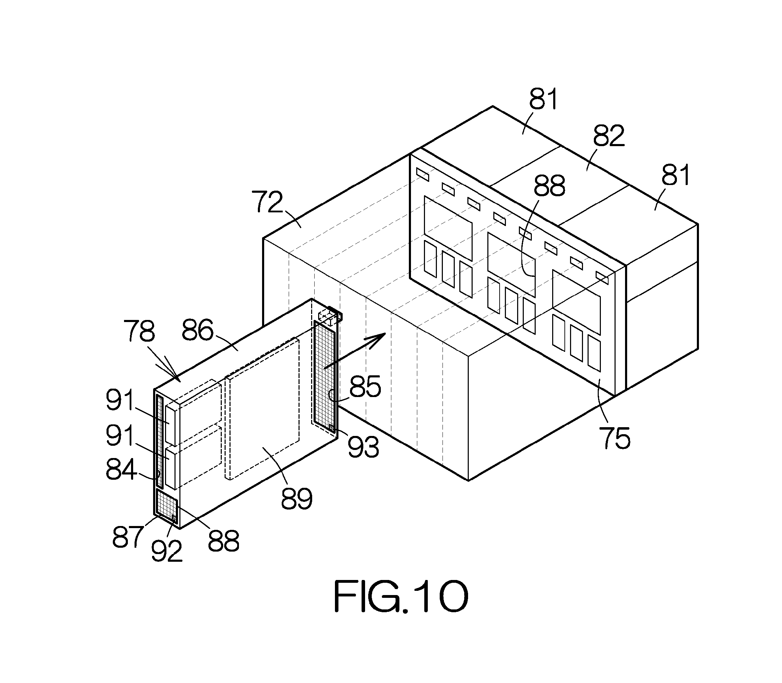

As depicted in FIG. 10, a hollow is defined in an enclosure 86 in the individual server blade 78. The hollow extends from a front-side opening 84 of the enclosure 86 to a rear-side opening 85 of the enclosure 86. The front-side opening 84 is closed with a front panel 87, for example. The rear-side opening 85 is closed with the backplate 75. Gratings 88 are formed in the front panel 87 and the backplate 75 for intake and discharge of air. A motherboard 89 and hard disk drives (HDDs) 91 are placed in the hollow.

The individual server blade 78 includes an inflow temperature sensor 92 located in the front-side opening 84. Likewise, the individual server blade 78 includes an outflow temperature sensor 93 located in the rear-side opening 85. The inflow temperature sensor 92 is configured to detect the temperature of air flowing into the enclosure 86 through the front-side opening 84, namely the intake air temperature. The inflow temperature sensor 92 provides an inflow temperature measuring section. The outflow temperature sensor 93 is configured to detect the temperature of air flowing out of the enclosure 86 through the rear-side opening 85, namely the discharged air temperature. The outflow temperature sensor 93 provides an outflow temperature measuring section.

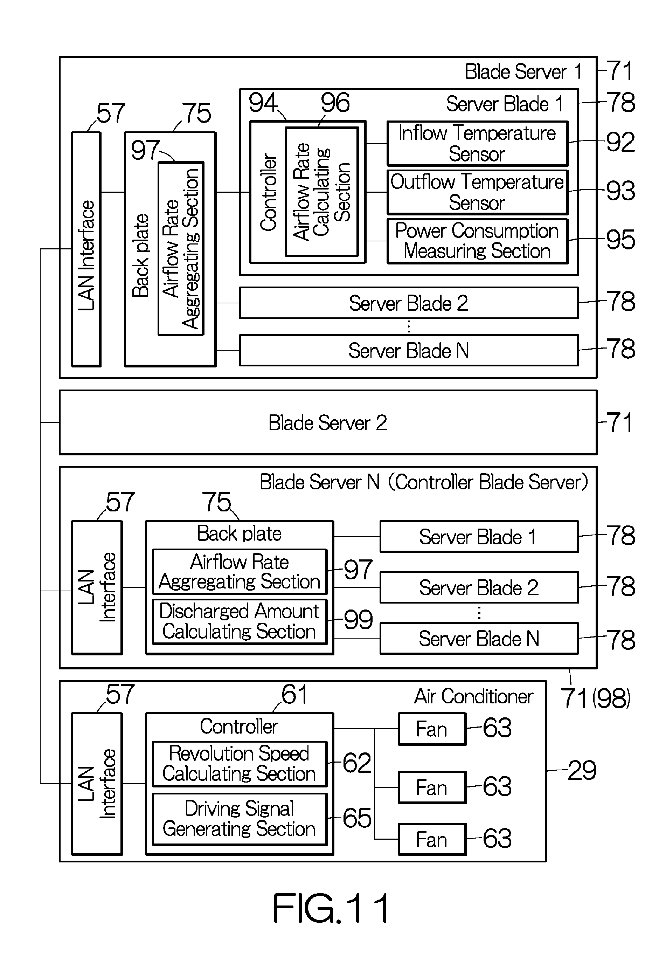

As depicted in FIG. 11, the individual server blade 78 includes a controlling section, namely a controller 94. The aforementioned inflow temperature sensor 92 and outflow temperature sensor 93 are connected to the controller 94. An intake temperature signal and a discharge temperature signal are supplied to the controller 94 from the inflow temperature sensor 92 and the outflow temperature sensor 93. The intake temperature signal specifies the intake air temperature. The discharge temperature signal specifies the discharged air temperature.

A power consumption measuring section 95 is connected to the controller 94. The power consumption measuring section 95 is configured to measure the power consumption for the individual electronic components or for the individual blade servers in the same manner as described above. The power consumption measuring section 95 supplies a power consumption amount signal to the controller 94. The power consumption amount signal specifies the amount of the power consumption. The quantity of heat or heating energy of the electronic component or the blade server can be calculated based on the amount of the power consumption.

An airflow rate calculating section 96 is established in the controller 94. The intake temperature signal, the discharge temperature signal and the power consumption amount signal are supplied to the airflow rate calculating section 96. The airflow rate calculating section 96 calculates the quantity of heat at the electronic component or components based on the amount of the power consumption in the same manner as described above. The airflow rate calculating section 96 is configured to calculate the flow rate of the airflow in the same manner as described above.

An airflow rate aggregating section 97 is established in the backplate 75. The airflow rate information signals are supplied to the airflow rate aggregating section 97 from the individual server blades 78. The airflow rate aggregating section 97 aggregates the airflow rate for the entire blade server 71 based on the airflow rate information signals.

One of the blade servers 71 is designated as a controller server 98. The remainder of the blade servers 71 is connected to the controller server 98. LAN interfaces 57 are utilized to establish such connection in the same manner as described above. The airflow rate information signals are supplied to the airflow rate aggregating section 97 of the controller server 98 from the airflow rate aggregating sections 97 of the individual blade servers 71, respectively. The airflow rate aggregating section 97 of the controller server 98 aggregates the airflow rate for the entire rack 21 based on the airflow rate information signals supplied from the airflow rate aggregating sections 97.

A discharged amount calculating section 99 is established in the backplate 75 of the controller server 98. The discharged amount calculating section 99 calculates the discharged amount of the air conditioner 29 based on the aggregated airflow rate in the same manner as described above. The discharged amount calculating section 99 generates a control signal based on the calculated discharged amount in the same manner as the aforementioned discharged amount calculating section 59. The backplate 75 of the controller server 98 is connected to the controller 61 of the air conditioner 29.

When the fan units 82 operate, the flow of coolant, namely air is generated in the individual server blades 78 from the front-side opening 84 namely the intake surface to the rear-side opening 85 namely the discharge surface. The air receives heat from objects to be cooled, such as the motherboard 89 and the HDDs 91. The airflow serves to cool the motherboard 89 and the HDDs 91. The airflow flows out of the enclosure 86 through the rear-side opening 85.

The heated air is sucked into the air conditioner 29 through the intake opening 31. The air conditioner 29 cools the cooling medium namely air based on a conventional refrigeration cycle. The cool air is discharged from the discharge opening 32. The air conditioner 29 forms a circulating path of the air from the rear-side opening 85 of the server blade 78 to the front-side opening 84 of the server blade 78. The air conditioner 29 in this manner works to supply the cool air to the individual server blades 78. In this case, the discharged amount of the air conditioner is controlled in the aforementioned manner.

## Claims

1. An information processing apparatus system, comprising:

    an information processing apparatus or apparatuses configured to measure flow rate of coolant flowing from a coolant inflow surface of its enclosure to a coolant outflow surface of the enclosure; and
    a cooling apparatus configured to form a circulating path of the coolant from the coolant outflow surface to the coolant inflow surface, the cooling apparatus configured to control a discharged amount of the coolant based on the flow rate measured.

2. The information processing apparatus system according to claim 1, wherein the discharged amount of the coolant is set larger than the flow rate of the coolant.

3. The information processing apparatus system according to claim 2, further comprising a controller information processing apparatus configured to obtain measurement values of the flow rate from the information processing apparatus or apparatuses, the controller information processing apparatus configured to calculate the discharged amount of the cooling apparatus and to supply a control signal to the cooling apparatus based on the discharged amount calculated.

4. The information processing apparatus system according to claim 3, further comprising a rack configured to contain the information processing apparatus or apparatuses and the controller information processing apparatus.

5. The information processing apparatus system according to claim 1, wherein the enclosure of the information processing apparatus contains an information processing apparatus unit or units, the flow rate of the coolant flowing through the enclosure being measured individually at the information processing apparatus unit or units.

6. A method of controlling an information processing apparatus system, the method comprising:

    measuring, at an information processing apparatus or apparatuses, flow rate of coolant flowing from a coolant inflow surface of an enclosure of the information processing apparatus or individual one of the information processing apparatuses to a coolant outflow surface of the enclosure; and
    controlling, based on the flow rate measured, a discharged amount of the coolant from a cooling apparatus configured to form a circulating path of the coolant from the coolant outflow surface of the enclosure to the coolant inflow surface of the enclosure.

7. The method according to claim 6, wherein the discharged amount of the coolant is set larger than the flow rate of the coolant.

8. An information processing apparatus comprising:

    an enclosure enclosing an object to be cooled;

an inflow temperature measuring section configured to measure temperature of coolant flowing into the enclosure through a coolant inflow surface of the enclosure;

an outflow temperature measuring section configured to measure temperature of the coolant flowing out of the enclosure through a coolant outflow surface of the enclosure;

a power consumption measuring section configured to measure power consumption of the object; and

a controlling section configured to calculate flow rate of the coolant flowing from the coolant inflow surface to the coolant outflow surface based on the temperature measured at the inflow temperature measuring section, the temperature measured at the outflow temperature measuring section and the power consumption measured at the power consumption measuring section.

9. The information processing apparatus according to claim 8, wherein the inflow temperature measuring section is configured to obtain temperature information specifying temperature from measurement points located along the coolant inflow surface.

10. The information processing apparatus according to claim 8 or 9, wherein the outflow temperature measuring section is configured to obtain temperature information specifying temperature from measurement points located along the coolant outflow surface.

11. The information processing apparatus according to any one of claims 8-10, wherein a constriction is formed in the enclosure at the coolant inflow surface and the coolant outflow surface, the constriction narrowing a passage of the coolant flowing from the coolant inflow surface to the coolant outflow surface, the measurement points being located in the constriction.

12. A method of cooling an information processing apparatus, the method comprising:

measuring temperature of coolant flowing into an enclosure through a coolant inflow surface of the enclosure, the enclosure enclosing an object to be cooled;

measuring temperature of the coolant flowing out of the enclosure through a coolant outflow surface of he enclosure;

measuring power consumption of the object; and

calculating flow rate of the coolant flowing from the coolant inflow surface to the coolant outflow surface based on the temperature measured at the inflow temperature measuring section, the temperature measured at the outflow temperature measuring section and the power consumption measured at the power consumption measuring section.

FIG.1

FIG.2

Server 1 — 12

57

53

Controller

Inflow Temperature Sensor — 51

Airflow Rate Calculating Section — 55

Outflow Temperature Sensor — 52

Power Consumption Measuring Section — 54

LAN Interface

---

Server 2 — 12

57

53

Controller

Inflow Temperature Sensor — 51

Airflow Rate Calculating Section — 55

Outflow Temperature Sensor — 52

Power Consumption Measuring Section — 54

LAN Interface

⋮

12(56)

---

Server N (Controller Server)

57

53

Controller

Airflow Rate Calculating Section — 55

Airflow Rate Aggregating Section — 58

Discharged Amount Calculating Section — 59

Inflow Temperature Sensor — 51

Outflow Temperature Sensor — 52

Power Consumption Measuring Section — 54

LAN Interface

⋮

---

Air Conditioner

57

61

Controller

Revolution Speed Calculating Section — 62

Driving Signal Generating Section — 65

Fan — 63

Fan — 63

Fan — 63

LAN Interface

— 29

FIG.3

12

FIG.4

FIG.5

FIG.6

**57** **53** Server 1 ⎯**12**

LAN Interface **57**

Controller

Airflow Rate Calculating Section
**55**

Axial Fan ⎯**48**

Axial Fan ⎯**48**

Axial Fan ⎯**48**

# FIG.7

**57** **53** Server 1 ⎯**12**

LAN Interface

Controller

Airflow Rate Calculating Section
**55**

Anemometer ⎯**66**

# FIG.8

FIG.9

EP 2 322 865 A1

FIG.10

EP 2 322 865 A1

Blade Server 1 — 71

Server Blade 1 — 78

94  96

Controller

Airflow Rate Calculating Section

Inflow Temperature Sensor — 92

Outflow Temperature Sensor — 93

Power Consumption Measuring Section — 95

57  75

97

LAN Interface

Back plate

Airflow Rate Aggregating Section

Server Blade 2 — 78

Server Blade N — 78

Blade Server 2 — 71

Blade Server N (Controller Blade Server)

57  75

LAN Interface

Back plate

Airflow Rate Aggregating Section — 97

Discharged Amount Calculating Section — 99

Server Blade 1 — 78

Server Blade 2 — 78

Server Blade N — 78

71 (98)

Air Conditioner

57  61

LAN Interface

Controller

Revolution Speed Calculating Section — 62

Driving Signal Generating Section — 65

Fan — 63

Fan — 63

Fan — 63

29

FIG.11

## INTERNATIONAL SEARCH REPORT

| International application No. |
| --- |
| PCT/JP2008/063202 |

A.   CLASSIFICATION OF SUBJECT MATTER
*F24F11/04*(2006.01)i, *F24F7/06*(2006.01)i, *G06F1/20*(2006.01)i, *H05K7/20*
(2006.01)i

According to International Patent Classification (IPC) or to both national classification and IPC

B.   FIELDS SEARCHED

Minimum documentation searched (classification system followed by classification symbols)
F24F11/04, F24F7/06, G06F1/20, H05K7/20

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| A | JP 2007-300037 A   (Bit-isle Inc.), 15 November, 2007 (15.11.07), Claims 4, 5; Par. Nos. [0040] to [0059]; Figs. 8 to 10 (Family: none) | 1-12 |
| A | JP 2001-133023 A   (Mitsubishi Electric Corp.), 18 May, 2001 (18.05.01), Par. Nos. [0020] to [0026]; Figs. 1 to 5 & US 6539736 B1          & EP 1074796 A2 | 1-12 |
| A | JP 2006-507606 A  (American Power Conversion Corp.), 02 March, 2006 (02.03.06), Par. No. [0042]; Fig. 2 & US 2004/0099747 A1     & EP 1566086 A & WO 2004/049773 A2 | 1-12 |

☐  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 15 October, 2008 (15.10.08) | 28 October, 2008 (28.10.08) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

**EP 2 322 865 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6029195 U
- JP 2006064303 A
- JP 2003166729 A